## Europäisches Patentamt

## European Patent Office

## Office européen des brevets

(19)

(11) Veröffentlichungsnummer: **0 204 897**
**B1**

(12) # EUROPÄISCHE PATENTSCHRIFT

(45) Veröffentlichungstag der Patentschrift:
**24.05.89**

(51) Int. Cl.⁴: **G01D 3/04,** H03K 5/04

(21) Anmeldenummer: **86103378.5**

(22) Anmeldetag: **13.03.86**

(54) **Verfahren und Einrichtung zur Regelung des Tastverhältnisses eines elektrischen Signals.**

(30) Priorität: **19.04.85 DE 3514155**

(43) Veröffentlichungstag der Anmeldung:
**17.12.86 Patentblatt 86/51**

(45) Bekanntmachung des Hinweises auf die Patenterteilung:
**24.05.89 Patentblatt 89/21**

(84) Benannte Vertragsstaaten:
**AT CH DE FR GB IT LI NL SE**

(56) Entgegenhaltungen:
**DE-A- 3 046 797**
**DE-B- 2 061 588**

(73) Patentinhaber: **Dr. Johannes Heidenhain GmbH,
Postfach 1260, D-8225 Traunreut(DE)**

(72) Erfinder: **Schmitt, Walter, Ing. grad.,
Hochgernstrasse 22, D-8225 Traunreut(DE)**

## Beschreibung

Die Erfindung betrifft ein Verfahren und eine Einrichtung zur Regelung des Tastverhältnisses eines elektrischen Signals gemäß dem Oberbegriff des Anspruchs 1.

Inkrementale Meßsysteme, von denen die Erfindung ausgeht, liefern bekanntlich Impulse, deren Anzahl ein Maß für die lineare Verschiebung oder den Drehwinkel eines ersten Objekts bezüglich eines zweiten Objekts darstellt, deren gegenseitige Relativlage gemessen werden soll. Derartige lichtelektrische digitale Längen- oder Winkelmeßsysteme werden beispielsweise bei Bearbeitungsmaschinen zur Messung der Relativlage von zueinander verschieblichen Maschinenteilen zur Bearbeitung eines Werkstückes oder bei Meßmaschinen zur Ermittlung der Lage oder der Abmessungen eines Prüfobjekts eingesetzt.

Das Auflösungsvermögen derartiger Meßsysteme ist durch die Gitterkonstante der benutzten Präzisionsmaßstäbe begrenzt. Durch eine Interpolation kann die Meßauflösung erhöht werden. Die Höhe des Interpolationsgrades ist vor allem von der Güte der Signalparameter abhängig. Fehlerhafte Signalparameter in Form von Amplitudenschwankungen, überlagerten Gleichspannungsanteilen, Phasenfehlern und in Form eines unzulässigen Oberwellengehaltes können einer derartigen Interpolation enge Grenzen setzen. Längen- und Winkelmeßsysteme mit einer Einrichtung zur Eliminierung solcher fehlerhafter Signalparameter sind bereits bekannt.

In der DE-OS 27 29 697 ist ein Meßsystem mit einer Einrichtung zur Korrektur fehlerhafter Signalparameter von Abtastsignalen beschrieben. Die ermittelten Abweichungen der Signalparameter werden als digitale Korrekturwerte in einem Speicher zur Korrektur der digitalisierten Abtastsignale durch einen Rechner vor der Interpolation gespeichert. Bei diesem Verfahren sind eine Speichereinheit und relativ umfangreiche Rechenoperationen notwendig.

In der DE-PS 19 45 206 ist eine Einrichtung zur Interpolation von weg- bzw. winkelabhängigen elektrischen Signalen offenbart, bei der die elektrischen Signale über eine Reihe von Komparatoren mit unterschiedlichen Triggerniveaus geführt werden. Diese unterschiedlichen Triggerniveaus werden an die vorgegebenen Signalformen und Amplituden der elektrischen Signale angepaßt. Hierzu wird in Abhängigkeit von der Amplitude des elektrischen Signals ein Referenzsignal erzeugt, welches die Triggerniveaus entsprechend den vorgegebenen Interpolationsschritten anpaßt bzw. die Amplitude des elektrischen Signals durch variable Verstärkung in Abhängigkeit vom Referenzsignal konstant hält. Bei dieser Einrichtung wird kontinuierlich im Betrieb bei allen Frequenzen des elektrischen Signales ein Korrektursignal gebildet und dem elektrischen Signal bzw. dem Steuereingang der Komparatoren überlagert.

In der DE-OS 30 46 797 ist eine Korrektur von Fehlern beschrieben, die sich aus einer Gleichstromniveauverschiebung des elektrischen sinusförmigen Signals eines lichtelektrischen Meßsystems ergeben. Aus den Maximal- und Minimalwerten des elektrischen Signals wird ein Mittelwert erzeugt, der jeweils nahe den Extremwerten mit einem Bezugswert zur Erzeugung eines Fehlersignals verglichen wird. Dieses Fehlersignal wird dem elektrischen Signal korrigierend überlagert. Die Korrektur erfolgt in Abhängigkeit eines weiteren um 90° phasenverschobenen elektrischen Signals.

Aus der DE-PS 24 59 749 ist eine Einrichtung zur Geberüberwachung bei einer Drehzahlmessung bekannt. Das bewegungsabhängige elektrische Signal wird mittels eines Integrators in ein, dem Tastverhältnis proportionales Signal umgeformt. Dieses Signal wird mit einem oberen und unteren Bezugsgrenzwert verglichen. Bei Über- bzw. Unterschreiten dieser Bezugswerte wird ein Alarmsignal ausgelöst.

Die DE-AS 20 61 588 offenbart eine Schaltung zur Regelung des Tastverhältnisses von Impulsfolgen. Dabei ist im Rückführungskanal des geschlossenen Regelkreises ein Tiefpaß angeordnet, der nur Stellgrößen unterhalb einer vorgegebenen Frequenz einem Verstärker zuführt.

Diese bekannten Verfahren und Einrichtungen haben den gemeinsamen Nachteil, daß bei Wiederinbetriebnahme des Meßsystems nach Betriebspausen kein Fehlersignal zur Regelung des fehlerhaften elektrischen Signals vorliegt, da die elektrischen Bauelemente im Regelkreis nur im eingeschwungenen Zustand das zur Regelung benötigte Stellsignal liefern können. Des weiteren wird bei den bekannten Verfahren und Einrichtungen bei allen Frequenzen des periodischen elektrischen Signals ein Fehlersignal gebildet. Bei niederen Frequenzen des periodischen elektrischen Signals stellt dieses Fehlersignal aber nicht das zur Regelung benötigte Signal dar, um Temperatur-, Alterungs- oder Drifteinflüsse zu eliminieren, da die im Regelkreis verwendeten elektronischen Bauteile nur innerhalb eines zulässigen Frequenzbereiches zuverlässig arbeiten.

Der Erfindung liegt die Aufgabe zugrunde, bei derartigen Meßsystemen fehlerhafte Signalparameter, hervorgerufen beispielsweise durch Temperatur-, Alterungs- oder Drifteinflüsse zu eliminieren, indem die Tastverhältnisse der Rechtecksignale konstant gehalten werden. Die erfindungsgemäße Einrichtung soll eine Korrektur von Signalparametern möglichst einfach und störungssicher ermöglichen.

Diese Aufgabe wird erfindungsgemäß durch die Merkmale des Anspruchs 1 gelöst.

Ein mit der Erfindung erzielter Vorteil besteht insbesondere darin, daß zusätzliche Überlagerungsfehler, hervorgerufen durch das Frequenzverhalten der elektrischen Bauteile im Regelkreis, nicht auftreten können.

Ein weiterer, mit der Erfindung erzielter Vorteil besteht darin, daß die Regelung nach Betriebspausen sofort befriedigend arbeitet.

Ein Ausführungsbeispiel der erfindung wird anhand der Zeichnung näher erläutert.

Es zeigt

Figur 1 eine schematische Darstellung einer bevorzugten Schaltungsanordnung zur Anwendung des erfindungsgemäßen Verfahrens;

Figur 2 eine Einzelheit aus Figur 1;

Figur 3 ein Signaldiagramm.

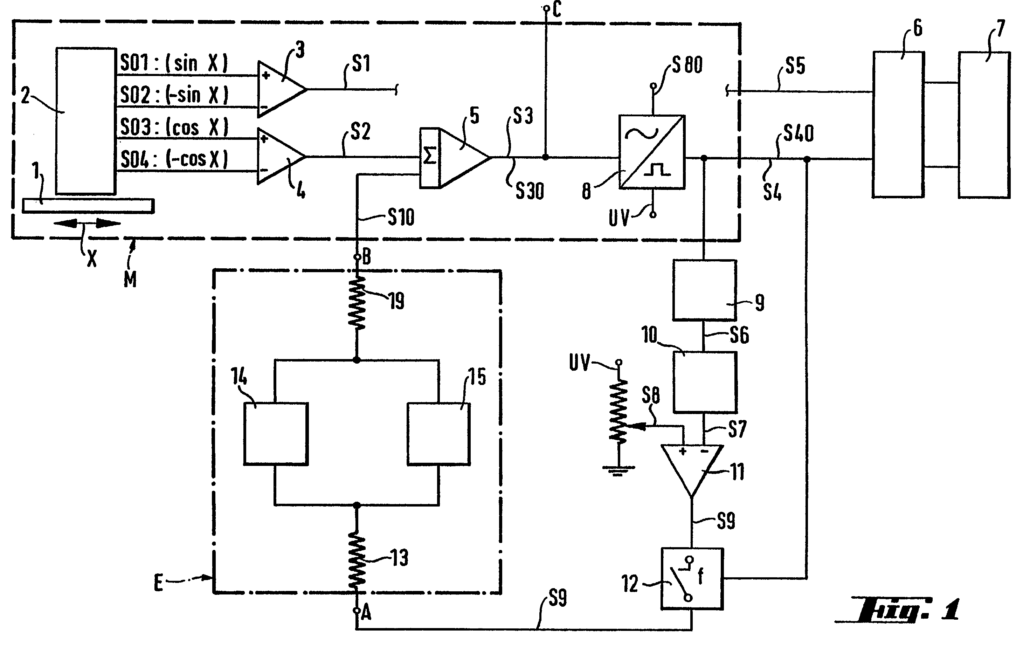

In Figur 1 ist ein bekanntes inkrementales, photoelektrisches Längenmeßsystem M zur Messung der Relativlage zweier zueinander verschiebbarer, nicht gezeigter Objekte dargestellt, die beispielsweise durch zwei Maschinenteile einer Bearbeitungsmaschine oder Meßmaschine gebildet sein können. Das Meßsystem M gibt zwei Rechtecksignale S4,S5 ab, deren Tastverhältnisse vor einer Weiterverarbeitung der Rechtecksignale S4,S5 auf einen vorgegebenen Wert eingeregelt werden. Ein mit dem ersten Objekt verbundener Gittermaßstab 1 bewegt sich relativ in Meßrichtung X zu einer mit dem zweiten Objekt verbundenen Abtasteinheit 2, die vier um je ein Viertel der Gitterkonstante zueinander versetzte Abtastgitter enthält, denen jeweils ein Photoelement zugeordnet ist. Die vier Abtastgitter bilden zwei Paare von jeweils um die halbe Gitterkonstante zueinander versetzten Abtastgittern. Die Abtasteinheit 2 erzeugt bei der Abtastung des Gittermaßstabes 1 mittels der vier jeweils um ein Viertel der Gitterkonstante zueinander versetzten Abtastgitter und der dazugehörigen Photoelemente vier ebenfalls jeweils um ein Viertel der Gitterkonstante zueinander phasenversetzte Abtastsignale S01 (sin X), S03 (cos X), S02(-sin X),S04(-cos X). Das erste Abtastsignal S01 und das um die halbe Gitterkonstante dazu phasenversetzte zweite Abtastsignal S02 werden einem ersteb Differebzverstärker 3 zur Bildung des ersten Meßsignals S1 (sin X) - (-sin X) zugeführt. Das dritte Abtastsignal S03 und das um die halbe Gitterkonstante dazu phasenversetzte vierte Abtastsignal S04 werden einem zweiten Differenzverstärker 4 zur Bildung des zweiten Meßsignals S2 (cos X) - (-cos X) zugeführt. Die beiden Meßsignale S1,S2 sind um ein Viertel der Gitterperiode zueinander phasenversetzt und im Idealfall zu ihrer Nullinie symmetrisch, da durch die Differenzbildung der Abtastsignale S01,S02 und der Abtastsignale S03,S04 in den Differenzverstärkern 3,4 ihre Gleichstrom- bzw. Gleichspannungsanteile GA eliminiert werden. Bei der Differenzbildung können aber Fehler auftreten, wenn jeweils die Photoelemente der beiden Paare von Photoelementen in ihrer Charakteristik voneinander abweichen, was bei handelsüblichen Photoelementen im allgemeinen der Fall sein wird. Des weiteren kann eine Änderung der Charakteristik der Photoelemente beispielsweise durch Temperatur-, Alterungs und Drifteinflüsse hervorgerufen werden. Unterschiedliche Abstände zwischen den einzelnen Photoelementen und den Lichtquellen, zwischen den Photoelementen und den Abtastgittern, bzw. zwischen den Lichtquellen und dem Gittermaßstab 1 können weiterhin zu einem Gleichstrom- bzw. Gleichspannungsanteil GA der beiden Meßsignale S1,S2 führen.

Von diesen beiden Meßsignalen S1,S2 wird nachfolgend nur die Korrektur des zweiten Meßsignals S2 beschrieben, die Korrektur des ersten Meßsignals S1 verläuft hierzu identisch. Das Meßsignal S2 wird in einem Verstärker 5 noch zusätzlich verstärkt, bevor es in einem Trigger 8 in ein Rechtecksignal S4 umgewandelt und zur Weiterverarbeitung einer Auswerteeinheit 6 mit einer Interpolationseinrichtung und einem Vor- und Rückwärtszähler sowie einer Anzeigeeinheit 7 zur Anzeige der Positionsmeßwerte für die Relativlage der beiden zueinander verschieblichen Objekte zugeführt wird. Für die fehlerlose weg- bzw. winkelabhängige Auswertung und Interpolation muß das Rechtecksignal S4 ein konstantes Tastverhältnis aufweisen.

Zur Regelung des Tastverhältnisses wird das Meßsignal S2 nach der Verstärkung dem Trigger 8 zugeführt, welcher das verstärkte Meßsignal S3 in ein Rechtecksignal S4 mit nahezu konstanten Signalpegeln SB,SU umwandelt. Die Triggerschwelle des Triggers 8 wird durch ein Steuersignal S80 bevorzugt auf dem Niveau der Nullinie N des verstärkten Meßsignals S3 konstant gehalten Der obere Signalpegel SB des Rechtecksignals S4 ist nur abhängig von der Trigger-Versorgungsspannung UV. Das Rechtecksignal S4 wird einer Schaltstufe 9 zugeführt, in der die Signalpegel SB,SU stabilisiert werden, so daß am Ausgang ein stabilisiertes Rechtecksignal S6 mit konstanten Signalpegeln SB,SU ansteht.

Als Tastverhältnis ist das Verhältnis der Impulsdauer T1 zur Periodendauer T = T1 + T2 definiert, die Pausendauer ist mit T2 bezeichnet.

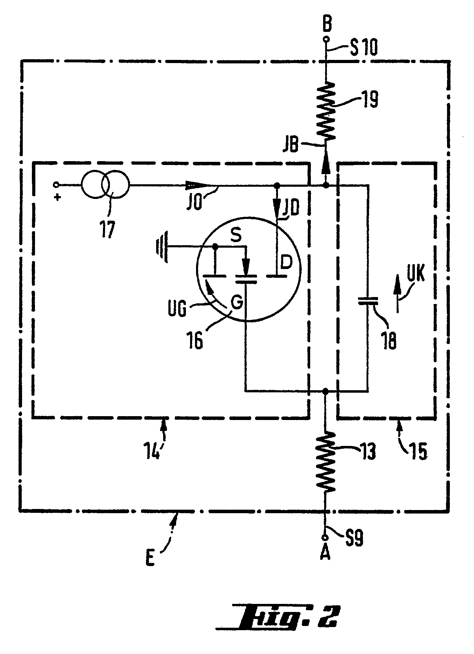

Für die Regelung des Tastverhältnisses auf einen vorgegebenen Wert wird das stabilisierte Rechtecksignal S6 einem Integrierglied 10 zugeführt, welches in eingeschwungenem Zustand das stabilisierte Rechtecksignal S6 in ein, dem Tastverhältnis proportionales Istsignal S7 umsetzt. In einem Regelverstärker 11 wird dieses Istsignal S7 mit einem konstanten Sollsignal S8, entsprechend dem geforderten konstanten Tastverhältnis verglichen und ein vergleichsabhängiges Differenzsignal S9 gebildet. Im allgemeinen ist, wie in Figur 1 gezeigt, das konstante Sollsignal S8 von der Trigger-Versorgungsspannung UV abgeleitet. Das Differenzsignal S9 wird einem frequenzabhängigen Schalter 12 zugeführt, der den analogen Regelkreis unterhalb einer, an diesem Schalter 12 einstellbaren Signalfrequenz f unterbricht. Oberhalb der eingestellten Signalfrequenz f gelangt das Differenzsignal S9 zu einer Anordnung E, welche aus einem Vorwiderstand 13, einer Stelleinheit 14 zur Bildung eines Stellsignals S10, einer der Stelleinheit 14 parallel geschalteten Speichereinheit 15 und einem Widerstand 19 besteht. Die Stelleinheit 14 besteht gemäß Figur 2 aus einem MOS-FET 16 mit einer Konstantstromquelle 17, während die Speichereinheit 15 durch einen Kondensator 18 gebildet wird. Das Gate G des MOS-FET 16 ist mit dem Vorwiderstand 13, welcher bevorzugt sehr hochohmig ausgelegt ist, verbunden. Die Source S liegt an Masse, Drain D ist mit der zweiten Elektrode des Kondensators 18, mit dem nachfolgenden Widerstand 19 und mit der Konstantstromquelle 17 verbunden.

Das Differenzsignal S9 liegt somit am Gate G des MOS-FET und an einer Elektrode des Kondensators 18 an, so daß sich eine Gatespannung UG und eine Kondensatorspannung UK aufbaut. Abhängig von diesen Spannungen UG,UK und somit abhängig von dem Differenzsignal S9 fließt ein Quellenstrom J0 von der Konstantstromquelle 17 ab. Ein geringer Teil des Quellenstroms J0 fließt über die Drain D als Drainstrom JD zur Source S, der andere Teil des Quellenstroms J0 gelangt als Stellstrom JB über einen Widerstand 19, in dem der Stellstrom JB in ein Stellsignal S10 umgewandelt wird, zum Verstärker 5. Der Verstärker 5 ist als Summenverstärker ausgebildet, am Eingang dieses Verstärkers 5 stehen das zu korrigierende Meßsignal S2 und das Stellsignal S10 zur Regelung des Tastverhältnisses des Rechtecksignals S4 an. Beide anliegenden Signale S2 und S10 werden mittels des Verstärkers 5 summiert und verstärkt, am Ausgang des Verstärkers 5 erhält man somit ein korrigiertes Meßsignal S30, das durch den Trigger 8 in ein korrigiertes Rechtecksignal S40 mit vorgegebenem, konstantem Tastverhältnis umgewandelt wird.

Beim Unterschreiten der am frequenzabhängigen Schalter 12 eingestellten unteren Frequenz f des Rechtecksignals S4, und somit auch der Frequenz des Meßsignals S2 gelangt das Differenzsignal S9 wegen des geöffneten Schalters 12 nicht mehr zur Stelleinheit 14 und zur Speichereinheit 15. In diesem Fall wird der Quellenstrom J0, der Drainstrom JD und der Stellstrom JB nur aufgrund der gespeicherten Ladung am Kondensator 18 gesteuert.

Diese gespeicherte Ladung ist dem Differenzsignal S9 proportional, welches vor dem Unterschreiten der eingestellten Frequenz vom Differenzverstärker 11 gebildet wurde, und noch bei geschlossenem Schalter 12 über den Vorwiderstand 13 an eine Elektrode des Kondensators 18 gelangt ist. Auch bei längeren Betriebspausen wird sofort nach Wiederinbetriebnahme des Meßsystems M der Stellstrom JB von der gespeicherten Ladung des Kondensators 18 bestimmt. Bei der gezeigten Ausführung wirkt die Parallelschaltung der Stelleinheit 14 und der Speichereinheit 15 als Integrierglied, so daß nur Stellsignale S10 einer bestimmbaren Dauer dem Meßsignal S2 additiv überlagert werden.

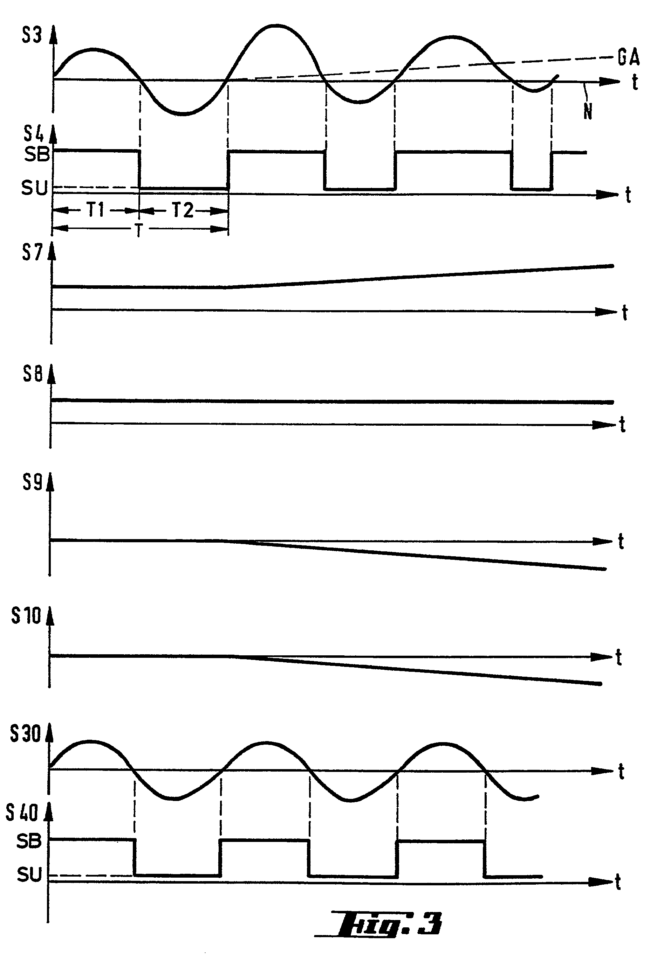

In Figur 3 ist ein Signaldiagramm der an den verschiedenen Bausteinen der Schaltungsanordnung gemäß Figur 1 auftretenden Signale gezeigt.

Das sinusförmige verstärkte Meßsignal S3 ist im fehlerfreien Zustand ohne einen Gleichstrom- bzw. Gleichspannungsanteil GA, nach der gezeigten ersten Periodendauer T ist diesem verstärkten Meßsignal S3 zunehmend durch Drifteinflüsse der Gleichstrom- bzw. Gleichspannungsanteil GA überlagert. Das nach dem Trigger 8 erhaltene Rechtecksignal S4 ist von den Amplituden des verstärkten Meßsignals S3 unabhängig. Der obere Signalpegel SB und der untere Signalpegel SU sind nur von der Trigger-Versorgungsspannung UV und den Eigenschaften des Triggers 8 abhängig. Die Triggerschwelle ist durch das Steuersignal S80 auf die Nullinie N fest eingestellt.

Das dem Tastverhältnis des Rechtecksignals S4, proportionale Istsignal S7 wird mit dem einstellbaren Sollsignal S8, welches proportional dem geforderten konstanten Tastverhältnis ist, verglichen und das Differenzsignal S9 gebildet. Diesem Differenzsignal S9 ist das Stellsignal S10 proportional, welches im Summenverstärker 5 addiert mit dem Meßsignal S2 ein korrigiertes verstärktes Meßsignal S30 ergibt. Die Verarbeitung des korrigierten verstärkten Meßsignals S30 erfolgt ebenso, wie dies in der Beschreibung bei Figur 1 für das verstärkte Meßsignal S3 erläutert wurde, so daß nach dem Trigger 8 ein korrigiertes Rechtecksignal S40 mit gefordertem konstantem Tastverhältnis zur Verfügung steht. Im gezeigten Fall ist die Parallelschaltung der Stelleinheit 14 und der Speichereinheit 15 als nicht invertierend angenommen.

Beschrieben ist nur die Regelung des Rechtecksignals S4, das von dem verstärkten Meßsignal S3 abgeleitet wurde, es ist aber auch möglich, je ein Rechtecksignal, dessen Tastverhältnis geregelt werden kann, direkt von den Abtastsignalen oder von den noch nicht verstärkten Meßsignalen abzuleiten.

Das Rechtecksignal S4 bzw. das korrigierte Rechtecksignal S40 wird im gezeigten Beispiel der Auswerteeinheit 6 zur Weiterverarbeitung zugeführt. In der Praxis ist es auch üblich, das verstärkte Abtastsignal S3 bzw. das korrigierte verstärkte Abtastsignal S30 beispielsweise zu einem, außerhalb des Meßsystems M angebrachten Anschluß C zu leiten, an dem es zur Weiterverarbeitung abgenommen werden kann.

Es ist offensichtlich, daß die Abtastsignale und die Meßsignale auch von der Sinusform abweichen können. Die Konstantstromquelle muß nicht wie gezeigt ausgeführt sein, sie kann auch von einem Widerstand gebildet werden.

Der frequenzabhängige Schalter kann aus einer Anordnung bestehen, die einen Frequenz-Gleichspannungs-Umsetzer und ein Relais umfaßt. Der Frequenz-Gleichspannungs-Umsetzer gibt dabei eine Gleichspannung ab, deren Größe proportional zur Frequenz des Meßsignals bzw. des getriggerten Meßsignals ist. Abhängig von dieser Gleichspannung werden die Kontakte eines Relais betätigt.

Als Speichereinheit kann auch ein Kondensator dienen, welcher einem MOS-Verstärker parallel geschaltet ist. Das, dem Tastverhältnis proportionale Istsignal wird in diesem Fall dem frequenzabhängigen Schalter zugeführt und gelangt bei geschlossenem Schalter zu einem Eingang des MOS-Verstärkers, an dem eine Elektrode des parallel geschalteten Kondensators angeschlossen ist. An einem zweiten Eingang des MOS-Verstärkers wird das Sollsignal angelegt, so daß am Ausgang des MOS-Verstärkers, an dem eine zweite Elektrode des Kondensators angeschlossen ist, das Stellsignal abgenommen werden kann.

Durch das Stellsignal kann auch die Triggerschwelle des Triggers verändert werden, indem das Stellsignal dem Steuersignal des Triggers zur Regelung des Tastverhältnisses eines Rechtecksignals überlagert wird.

Der frequenzabhängige Schalter ist in der beschriebenen Ausführungsform so ausgebildet, daß er nur oberhalb einer einstellbaren Frequenz f des verstärkten Meßsignals den Regelkreis schließt. Dieser Schalter kann aber auch die Eigenschaft besitzen, daß er in nicht gezeigter Weise den Regelkreis nur innerhalb eines vorgegebenen Frequenzbereiches mit einer unteren und oberen einstellbaren Frequenz f geschlossen hält.

Die Anordnung mit der Stelleinheit und der Speichereinheit kann auch, bei Verwendung entsprechender Bauteile, in Reihe geschaltet sein.

Die Erfindung ist nicht auf lichtelektrische Meßeinrichtungen beschränkt, sondern auch bei magnetischen, induktiven und kapazitiven Meßeinrichtungen mit Erfolg anwendbar.

## Patentansprüche

1. Verfahren zur Regelung des Tastverhältnisses eines aus einem analogen periodischen Abtastsignal (S2) gewonnenen Digitalsignales (S4) bei einem digitalen Längen- oder Winkelmeßsystem, bei dem ein dem Tastverhältnis des Digitalsignales (S4) proportionales Istsignal (S7) mit einem dem Sollwert des Tastverhältnisses proportionalen Sollsignal (S8) verglichen und ein vergleichsabhängiges Differenzsignal (S9) gebildet wird, und bei dem nur innerhalb eines festgelegten Frequenzbereiches des Digitalsignales (S4) in Abhängigkeit vom augenblicklich auftretenden Differenzsignal (S9) in einer Anordnung (E) eine Stellgröße (S10) gebildet und mit dem Abtastsignal (S2) kombiniert wird.

2. Verfahren nach Anspruch 1, dadurch gekennzeichnet, daß außerhalb des festgelegten Frequenzbereiches des Digitalsignales (S4) die Stellgröße (S10) abhängig von einer in einer Speichereinheit (15) gespeicherten Größe gebildet wird, welche dem zuletzt, d.h. vor dem Unter- oder Überschreiten des eingestellten Frequenzbereiches, an der Speichereinheit (15) anliegenden Differenzsignal proportional ist.

3. Verfahren nach Anspruch 1 oder 2, dadurch gekennzeichnet, daß die Stellgröße (S10) mit dem Abtastsignal (S2) nur dann kombiniert wird, wenn sie eine vorgegebene Zeitdauer ansteht.

4. Verfahren nach einem der Ansprüche 1 bis 3, dadurch gekennzeichnet, daß die Stellgröße (S10) zum Abtastsignal (S2) addiert wird.

5. Einrichtung zur Durchführung des Verfahrens nach einem der vorhergehenden Ansprüche, bei der ein Maßstab (1) zur Erzeugung eines Abtastsignales (S2) relativ zu einer Abtasteinheit (2) bewegbar ist, bei der die Abtasteinheit (2) eine Baueinheit (8) zur Erzeugung eines Digitalsignales (S4) nachgeschaltet ist, bei der dieses Digitalsignal (S4) einem Integrierglied (10) zuführbar ist und nach dem Integrierglied (10) eine Baueinheit (11) zur Bildung eines Differenzsignales (S9) angeordnet ist, bei der dieser Baueinheit (11) eine Anordnung (E) zur Bildung einer Stellgröße (S10) nachgeschaltet ist, und bei der zwischen der Baueinheit (11) zur Bildung des Differenzsignales und der Anordnung (E) zur Bildung der Stellgröße ein frequenzabhängiger Schalter (12) eingefügt ist.

6. Einrichtung nach Anspruch 5, dadurch gekennzeichnet, daß die Anordnung (E) zur Bildung der Stellgröße (S10) eine Parallelschaltung einer Stelleinheit (14) mit einer Speichereinheit (15) enthält.

7. Einrichtung nach Anspruch 6, dadurch gekennzeichnet, daß die Stelleinheit (14) aus einem MOS-FET (16) besteht, an dessen Drain-Elektrode (D) eine Konstantstromquelle (17) angeschlossen ist und an dessen Gate-Eingang (G) das Differenzsignal (S9) anliegt.

8. Einrichtung nach Anspruch 6, dadurch gekennzeichnet, daß die Speichereinheit (15) aus einem Kondensator (18) besteht.

## Claims

1. Method of controlling the mark-space ratio of a digital signal (S4) derived from an analog periodic sensor signal (S2) in a digital length or angle measuring system, in which an actual value signal (S7) proportional to the mark-space ratio of the digital signal (S4) is compared with a command signal (S8) proportional to the command value of the mark-space ratio and a difference signal (S9) dependent on the comparison is formed, and in which a setting value (S10) is formed in an arrangement (E) in dependence upon the instantaneously appearing difference signal (S9) only within a fixed frequency region of the digital signal (S4) and is combined with the sensor signal (S2).

2. Method according to claim 1, characterized in that outside the fixed frequency region of the digital signal (S4) the setting value (S10) is formed in dependence upon a magnitude stored in a storage unit (15), which is proportional to the last difference signal applied to the storage unit (15), i.e. before the undershooting or overshooting the set frequency region.

3. Method according to claim 1 or 2, characterized in that the setting value (S10) is only combined with the sensor signal (S2) when it obtains for a predetermined time duration.

4. Method according to one of claims 1 to 3, characterized in that the setting value (S10) is added to the sensor signal (S2).

5. Device for carrying out the method according to one of the preceding claims, in which a measuring scale (1) for generating a sensor signal (S2) is movable relative to a sensing unit (2), in which the sensing unit (2) is connected to a unit (8) for generating a digital signal (S4), in which this digital signal (S4) is adapted to be applied to an integrating element (10) and after the integrating element (10) there is arranged a unit (11) for forming a difference signal (S9), in which this unit (11) is connected to an arrangement (E) for forming a setting value, and in which a frequency-dependent switch (12) is introduced between the unit (11) for forming the difference signal and the arrangement (E) for forming the setting value.

6. Device according to claim 5, characterized in that the arrangement (E) for forming the setting value (S10) comprises a parallel circuit of a setting unit (14) with a storage unit (15).

7. Device according to claim 6, characterized in that the setting unit (14) consists of a MOS-FET (16), to whose drain electrode (D) is connected a constant current source (17) and to whose gate input (G) is applied the difference signal.

8. Device according to claim 6, characterized in that the storage unit (15) consists of a capacitor (18).

## Revendications

1. Procédé pour le réglage du taux d'impulsions d'un signal numérique (S4) obtenu à partir d'un signal d'exploration (S2) analogique périodique, dans un système numérique de mesure des longueurs ou des angles, dans lequel un signal effectif (S7), proportionnel au taux d'impulsions du signal numérique (S4), est comparé à un signal prescrit (S8) proportionnel à la valeur de consigne du taux d'impulsions, et un signal de différence (S9) dépendant de la comparaison est formé, et dans lequel, uniquement à l'intérieur d'une gamme déterminée de fréquences du signal numérique (S4), est formée, en fonction du signal de différence (S9) se présentant instantanément, dans un dispositif (E), une grandeur de réglage (S10) qui est combinée avec le signal d'exploration (S2).

2. Procédé selon la revendication 1, caractérisé par le fait qu'en dehors de la gamme déterminée de fréquences du signal numérique (S4), la grandeur de réglage (S10) est formée en fonction d'une grandeur mémorisée dans une unité de mémoire (15), ladite grandeur étant proportionnelle au signal de différence s'appliquant à l'unité de mémoire (15) en dernier lieu, c'est-à-dire avant dépassement par le haut ou par le bas de la gamme établie de fréquences.

3. Procédé selon la revendication 1 ou 2, caractérisé par le fait que la grandeur de réglage (S10) n'est combinée au signal d'exploration (S2) que lorsqu'elle atteint une durée donnée au préalable.

4. Procédé selon l'une quelconque des revendications 1 à 3, caractérisé par le fait que la grandeur de réglage (S10) est ajoutée au signal d'exploration (S2).

5. Dispositif pour l'exécution du procédé selon l'une quelconque des revendications précédentes, dans lequel une règle graduée (1) peut être déplacée, pour la production d'un signal d'exploration (S2), par rapport à une unité d'exploration (2), dans lequel à la suite de l'unité d'exploration (2) est monté un module (8) pour la production d'un signal numérique (S4), dans lequel ce signal numérique (S4) peut être amené à un circuit d'intégration (10) et, après le circuit d'intégration (10), se trouve disposé un module (11) pour la formation d'un signal de différence (S9), dans lequel, à la suite de ce module (11) est monté un dispositif (E) pour la formation d'une grandeur de réglage (S10), et dans lequel, entre le module (11) pour la formation du signal de différence et le dispositif (E) pour la formation de la grandeur de réglage, est introduit un commutateur (12) dépendant de la fréquence.

6. Dispositif selon la revendication 5, caractérisé par le fait que le dispositif (E) pour la formation de la grandeur de réglage (S10) comprend un montage en parallèle d'une unité de réglage (14) avec une unité de mémoire (15).

7. Dispositif selon la revendication 6, caractérisé par le fait que l'unité de réglage (14) consiste en un MOS-FET (16), à l'électrode drain (D) duquel une source de courant constant (17) est branchée, et à l'entrée de grille (G) duquel est appliqué le signal de différence (S9).

8. Dispositif selon la revendication 6, caractérisé par le fait que l'unité de mémoire (15) consiste en un condensateur (18).

**Fig. 1**

S01: (sin X)
S02: (-sin X)
S03: (cos X)
S04: (-cos X)

$\Sigma$

UV

f

E

**_Fig. 2_**

Fig. 3